# EUROPEAN PATENT APPLICATION

(11) **EP 4 811 993 A1**
(43) Date of publication of application: **23.09.2026**
(21) Application number: 26165114.5
(22) Date of filing: 16.03.2026
(51) Int. Cl.: H10K 71/12, B05C 5/02, H10F 71/10, H10K 71/15, H10K 85/50, H10K 71/13, H10K 71/40, H10K 30/40

(54) **APPARATUS FOR PRODUCING PEROVSKITE SOLAR CELL, AND METHOD FOR PRODUCING PEROVSKITE SOLAR CELL**

(30) Priority: 21.03.2025 JP 2025047489; 21.03.2025 JP 2025046954; 16.01.2026 JP 2026005585
(71) Applicant: Ricoh Company, Ltd., Ohta-ku, Tokyo 143-8555 (JP)
(72) Inventor: Kobayashi, Yukifumi, Ohta-ku 143-8555 (JP); Niino, Yukihito, Ohta-ku 143-8555 (JP); Tanaka, Yuuji, Ohta-ku 143-8555 (JP); Mukotaka, Hiroto, Ohta-ku 143-8555 (JP); Niihara, Takayuki, Ohta-ku 143-8555 (JP); Gamoh, Takamasa, Ohta-ku 143-8555 (JP)
(74) Representative: J A Kemp LLP

(57) **Abstract**

An apparatus (10) for producing a perovskite solar cell that includes: a perovskite precursor application device (11) configured to apply a perovskite precursor ink onto a substrate (18) to form a perovskite precursor film (19); a drying device (12) configured to dry the perovskite precursor film (19); a poor-solvent application device (13) configured to apply a poor solvent (17) from a slit nozzle (120) to the perovskite precursor film (19) that has been dried in a direction perpendicular to the substrate (18) without contacting the perovskite precursor film (19); a transport device (14) configured to horizontally transport the substrate (18) to which the poor solvent (17) has been applied; a removal device (15) configured to remove the poor solvent (17) from the perovskite precursor film (19) that has been horizontally transported; and a baking device (16) configured to bake the perovskite precursor film (19) from which the poor solvent (17) has been removed.

## Description

### BACKGROUND

### Technical Field

The present disclosure relates to an apparatus for producing a perovskite solar cell, and a method for producing a perovskite solar cell.

### Related Art

Conventionally, as a method for forming a perovskite layer in a perovskite solar cell, a method is known in which a perovskite precursor ink is applied onto a substrate and dried to obtain a perovskite crystalline film.

In particular, an anti-solvent method is known in which, after a perovskite precursor ink is applied, a poor solvent (anti-solvent) for perovskite is supplied to precipitate a large number of perovskite crystal nuclei, thereby forming a uniform crystalline film.

However, in attempting to form a uniform crystalline film by the conventional anti-solvent method, parameters such as the applied amount of the poor solvent and the contact time with the poor solvent should be appropriately and uniformly adjusted, with respect to the perovskite precursor ink.

If the parameters such as the applied amount of the poor solvent and the contact time with the poor solvent are not appropriate, the uniformity of perovskite crystals decreases, thereby causing variations in the conversion efficiency and durability of perovskite solar cells and resulting in a large number of defective products. For this reason, the conventional anti-solvent method is often performed manually, and thus it has been difficult to achieve a production apparatus capable of supporting mass production.

### SUMMARY

One aspect of the present invention aims to provide an apparatus for producing a perovskite solar cell, which forms a perovskite layer exhibiting excellent crystallinity and film uniformity by an antisolvent method.

Embodiments of the present invention provides an apparatus for producing a perovskite solar cell that includes: a perovskite precursor application device configured to apply a perovskite precursor ink onto a substrate to form a perovskite precursor film; a drying device configured to dry the perovskite precursor film; a poor-solvent application device configured to apply a poor solvent from a slit nozzle to the perovskite precursor film that has been dried in a direction perpendicular to the substrate without contacting the perovskite precursor film; a transport device configured to horizontally transport the substrate to which the poor solvent has been applied; a removal device configured to remove the poor solvent from the perovskite precursor film that has been horizontally transported; and a baking device configured to bake the perovskite precursor film from which the poor solvent has been removed.

Embodiments of the present invention provides a method for producing a perovskite solar cell that includes: applying a perovskite precursor ink onto a substrate to form a perovskite precursor film; drying the perovskite precursor film; applying a poor solvent from a slit nozzle to the perovskite precursor film that has been dried in a direction perpendicular to the substrate without contacting the substrate; horizontally transporting the substrate to which the poor solvent has been applied; removing the poor solvent from the perovskite precursor film to which the poor solvent has been applied; and baking the perovskite precursor film from which the poor solvent has been removed.

According to one aspect of the present invention, an apparatus for producing a perovskite solar cell is provided, which forms a perovskite layer exhibiting excellent crystallinity and film uniformity by an antisolvent method.

### BRIEF DESCRIPTION OF THE DRAWINGS

A more complete appreciation of embodiments of the present disclosure and many of the attendant advantages and features thereof can be readily obtained and understood from the following detailed description with reference to the accompanying drawings, wherein:
FIG. 1 is a schematic view of a perovskite solar cell;
FIG. 2 is a schematic explanatory view of an apparatus for producing the perovskite solar cell illustrated in FIG. 1;
FIG. 3 is a schematic explanatory view of an apparatus for producing a perovskite solar cell;
FIG. 4 is a schematic explanatory view of an apparatus for producing a perovskite solar cell;
FIG. 5 is a perspective explanatory view of an apparatus for producing a perovskite solar cell;
FIG. 6A is a schematic view of a transport device in an apparatus for producing a perovskite solar cell;
FIG. 6B is a schematic view of a transport device in an apparatus for producing a perovskite solar cell;
FIG. 7 is a configuration example for optimizing an applied amount of a poor solvent in an apparatus for producing a perovskite solar cell;
FIG. 8A is an explanatory view of an air discharge port of a member constituting an air knife in an apparatus for producing a perovskite solar cell;
FIG. 8B is an explanatory view of air discharge ports of a member constituting an air knife in an apparatus for producing a perovskite solar cell;
FIG. 9 is an explanatory view of a conventional removal device;
FIG. 10 is an explanatory view of a poor-solvent removal device in an apparatus for producing a perovskite solar cell;
FIG. 11 is an explanatory view of a removal device in an apparatus for producing a perovskite solar cell; and
FIG. 12 is an explanatory view of a poor-solvent application device having a slit nozzle in an apparatus for producing a perovskite solar cell.

The accompanying drawings are intended to depict embodiments of the present disclosure and should not be interpreted to limit the scope thereof. The accompanying drawings are not to be considered as drawn to scale unless explicitly noted. Also, identical or similar reference numerals designate identical or similar components throughout the several views.

### DETAILED DESCRIPTION

In describing embodiments illustrated in the drawings, specific terminology is employed for the sake of clarity. However, the disclosure of this specification is not intended to be limited to the specific terminology so selected and it is to be understood that each specific element includes all technical equivalents that have a similar function, operate in a similar manner, and achieve a similar result.

Referring now to the drawings, embodiments of the present disclosure are described below. As used herein, the singular forms "a," "an," and "the" are intended to include the plural forms as well, unless the context clearly indicates otherwise.

### (Perovskite solar cell)

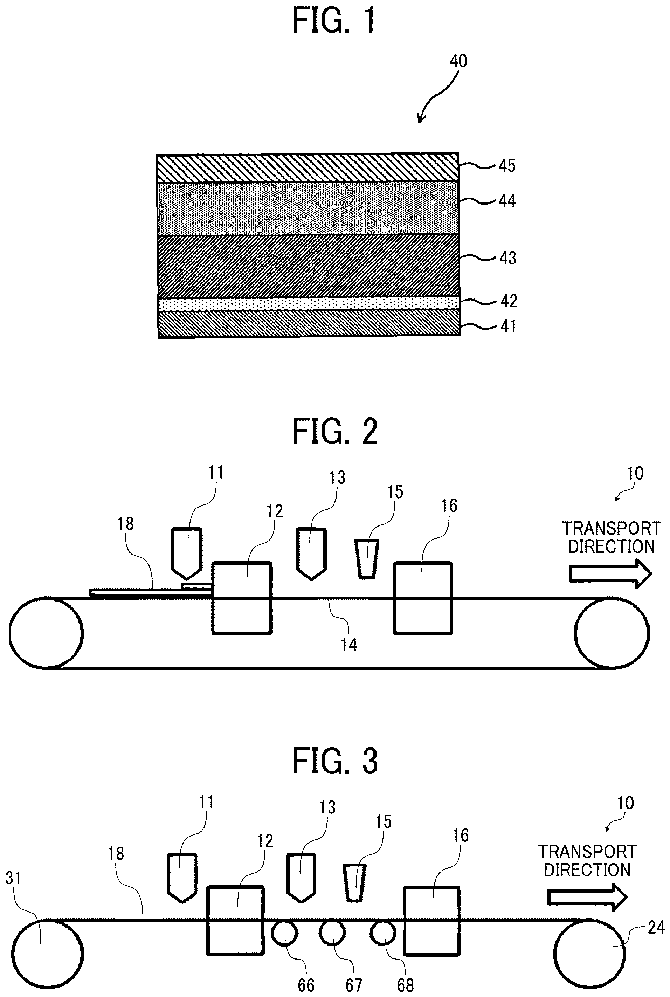

FIG. 1 is a schematic view of a perovskite solar cell. A photoelectric conversion element 40 includes a first electrode 41, an electron transport layer 42, a photoelectric conversion layer 43, a hole transport layer 44, and a second electrode 45. The first electrode 41 or the second electrode 45 has light-transmitting properties that allow light contributing to photoelectric conversion to pass therethrough.

### (Apparatus and method for producing perovskite solar cell)

FIG. 2 is a schematic view of an apparatus for producing the perovskite solar cell. An apparatus 10 for producing a perovskite solar cell according to one embodiment of the present invention includes a perovskite precursor application device 11, a drying device 12, a poor-solvent application device 13, a transport device 14, a poor-solvent removal device 15, and a baking device 16. The transport device 14 is provided with a belt-type transport unit and is thus capable of transporting a sheet-shaped substrate 18.

FIG. 3 is a schematic view of another apparatus for producing the perovskite solar cell. The apparatus 10 for producing the perovskite solar cell according to one embodiment of the present invention can produce the perovskite solar cell using a strip-shaped substrate 18. The apparatus 10 includes the perovskite precursor application device 11, the drying device 12, the poor-solvent application device 13, the poor-solvent removal device 15, and the baking device 16. Further, as a device for transporting the strip-shaped substrate 18, the apparatus 10 includes an unwinding roller 31, a winding roller 24, and substrate regulating units 66 to 68. When the substrate is supplied in the direction indicated by an arrow in the drawing, the substrate is supplied from the unwinding roller 31, and the strip-shaped substrate is transported under applied tension. Further, the strip-shaped substrate is transported while being maintained in a horizontal state by the substrate regulating units 66 to 68. The term "horizontal" described herein refers to a direction perpendicular to the direction of gravity. Note that the term "horizontal transport" refers to a configuration in which a liquid applied onto the substrate 18 can be retained on the substrate without separating therefrom within a certain inclination angle. The inclination angle is generally ±10 degrees or less from horizontal.

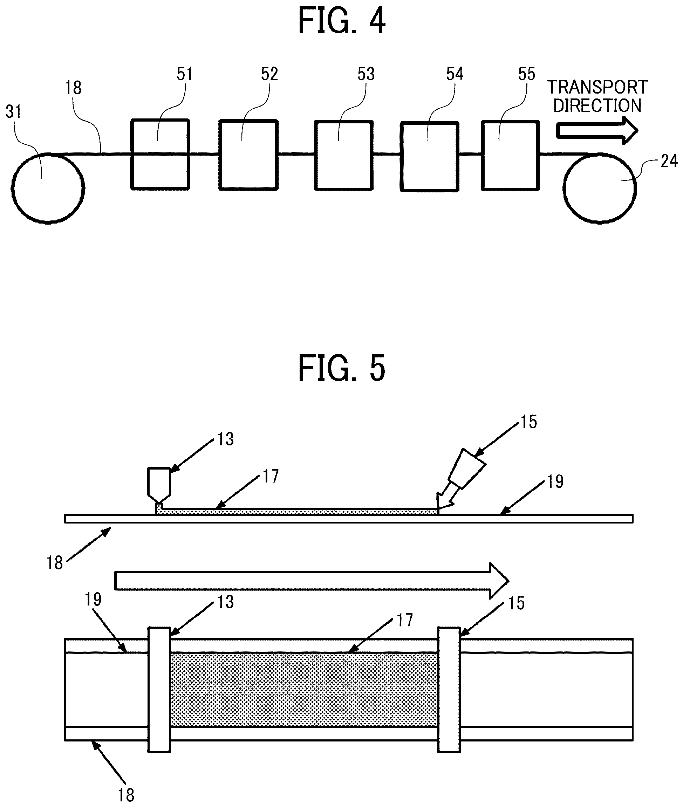

FIG. 4 is a schematic view of another apparatus for producing the perovskite solar cell by a roll-to-roll method using a strip-shaped flexible substrate. The strip-shaped flexible substrate 18 wound in a roll form is used, and the substrate is supplied from a rolled portion by the unwinding roller 31. A series of devices for sequentially forming respective layers on the substrate are arranged downstream of the unwinding roller 31. Specifically, the substrate sequentially passes through a first electrode forming device 51, an electron transport layer forming device 52, a perovskite layer forming device 53, a hole transport layer forming device 54, and a second electrode forming device 55. The substrate is then collected by the winding roller 24. Each of these devices (51 to 55) is provided with devices for forming the respective layers, such as an application device and a drying device as illustrated in FIG. 2.

Although FIG. 4 illustrates a configuration in which the devices are continuously connected from the unwinding roller 31 to the winding roller 24, the devices may be separated as appropriate as illustrated in FIG. 3. In such a case, the strip-shaped flexible substrate may be wound and stored in a roll form and then supplied in a roll form again to a subsequent device. FIG. 3 illustrates a case in which the substrate is supplied in a roll form to the perovskite layer forming device and wound into a roll form after completion of the perovskite layer forming step.

Next, a method for producing a perovskite solar cell according to one embodiment of the present invention is described. The method for producing a perovskite solar cell according to one embodiment of the present invention includes a transport step, a perovskite precursor application step, a drying step, a poor-solvent application step, a removal step, and a baking step. The method for producing a perovskite solar cell according to another embodiment of the present invention may include, as necessary, a step of forming a layer other than the perovskite layer.

The method for producing a perovskite solar cell according to one embodiment of the present invention can be carried out using the apparatus for producing a perovskite solar cell according to one embodiment of the present invention. Details are described below.

### <Perovskite precursor application device>

The perovskite precursor application device is a device for applying a perovskite precursor ink onto a substrate to form a perovskite precursor film. The perovskite precursor application device is not particularly limited and can be appropriately selected according to the purpose, and examples thereof include, but are not limited to, an air knife, a spraying device, a wire bar, a spin coating device, a roller coating device, a blade coating device, a gravure coating device, and an inkjet nozzle. Among these, it is preferable to use an inkjet nozzle because a perovskite precursor film can be formed at a desired location.

### -Perovskite precursor ink-

The perovskite precursor ink includes a solvent and at least two or more selected from one or more types of monovalent cations, one or more types of divalent metal cations, and one or more types of halide anions, and may further include other components as necessary.

### <Solvent>

The solvent is not particularly limited as long as it is capable of dissolving a compound including one or more types of monovalent cations, a compound including one or more types of divalent metal cations, and a compound including one or more types of halide anions, and can be appropriately selected according to the purpose.

Examples of the solvent include, but are not limited to, an alcohol, a ketone, an ether, a glycol ether cellosolve, a sulfone, and an amide.

Examples of the alcohol include, but are not limited to, methanol, ethanol, 1-propanol, 2-propanol, butanol, pentanol, hexanol, octanol, cyclopentanol, and cyclohexanol.

Examples of the ketone include, but are not limited to, methyl ethyl ketone, methyl isobutyl ketone, dimethyl ketone, diisobutyl ketone, cyclopentanone, cyclohexanone, and methylcyclohexanone.

Examples of the ether include, but are not limited to, diethyl ether, methyl tert-butyl ether, diisopropyl ether, dimethoxymethane, dimethoxyethane, 1,4-dioxane, 1,3-dioxolane, 4-methyldioxolane, tetrahydrofuran, methyltetrahydrofuran, anisole, and phenetole.

Examples of the glycol ether cellosolve include, but are not limited to, ethylene glycol monomethyl ether, ethylene glycol monoethyl ether, ethylene glycol monobutyl ether, ethylene glycol monoethyl ether acetate, and triethylene glycol dimethyl ether.

Examples of the sulfone include, but are not limited to, dimethyl sulfoxide.

Examples of the amine include, but are not limited to, N,N-dimethylformamide, N,N-diethylformamide, N,N-dimethylacetamide, and N,N-diethylacetamide.

A hydrogen atom in a hydrocarbon moiety included in the solvent may be substituted with a halogen atom such as a fluorine atom.

The content of the solvent is not particularly limited and can be appropriately selected according to the purpose. However, the content is preferably 50% by mass or less relative to the total amount of the solvent included in the perovskite precursor ink.

### <Monovalent cation>

In a liquid composition for forming a perovskite layer, the monovalent cation is present in an ionized state as part of a compound including the monovalent cation.

Examples of the monovalent cation include, but are not limited to, a monovalent organic cation and a monovalent inorganic cation. Among these, it is preferable that at least two or more selected from the monovalent organic cation and the monovalent inorganic cation are included. This makes it possible to increase the complexity of the crystal structure of the perovskite layer, thereby making the perovskite layer less prone to cracking and improving its durability.

Examples of the monovalent organic cation include, but are not limited to, an alkylamine compound ion.

The alkylamine compound ion is not particularly limited and can be appropriately selected according to the purpose. Examples thereof include, but are not limited to, a methylammonium ion (CH₃NH₃⁺; MA), an ethylammonium ion, an n-butylammonium ion, and a formamidinium ion (CH₃(NH₃)₂⁺; FA). These may be used singly or in combination of two or more.

Examples of the monovalent inorganic cation include, but are not limited to, a cesium ion, a potassium ion, and a rubidium ion. These may be used singly or in combination of two or more.

### <Divalent metal cation>

In a liquid composition for forming a perovskite layer, the divalent metal cation is present in an ionized state as part of a compound including the divalent metal cation.

The divalent metal cation is not particularly limited and can be appropriately selected according to the purpose. Examples thereof include, but are not limited to, a lead ion, an indium ion, an antimony ion, a tin ion, a copper ion, and a bismuth ion. These may be used singly or in combination of two or more.

### <Halide anion>

In a liquid composition for forming a perovskite layer, the halide anion is present in an ionized state as part of a compound including the halide anion.

The halide anion is not particularly limited as long as it is an element belonging to Group 17 of the periodic table as defined by the International Union of Pure and Applied Chemistry (IUPAC), and can be appropriately selected according to the purpose. Examples thereof include, but are not limited to, chlorine, bromine, and iodine. These may be used singly or in combination of two or more.

The content ratio of the monovalent cation, divalent metal cation, and halide anion included in a liquid composition for forming a perovskite layer is preferably 1:1:3. It should be noted that the ratio does not need to strictly match the above ratio due to crystal defects or the like, as long as the resulting layer can function as a photoelectric conversion layer.

### <Drying device>

The drying device is a device for drying the perovskite precursor film. The degree of drying is not particularly limited, as long as at least a part of the solvent in the applied film is removed.

The heating time of the drying device is not particularly limited and can be appropriately selected according to the purpose. The heating time can be adjusted according to the discharge amount of the ink and the performance of the printing device.

The drying device is not particularly limited and can be appropriately selected according to the purpose. Examples thereof include, but are not limited to, a hot-air heater and an infrared heater.

### <Poor-solvent application device>

The poor-solvent application device is a device for applying a poor solvent to the dried perovskite precursor film in a direction perpendicular to the substrate without contacting the perovskite precursor film.

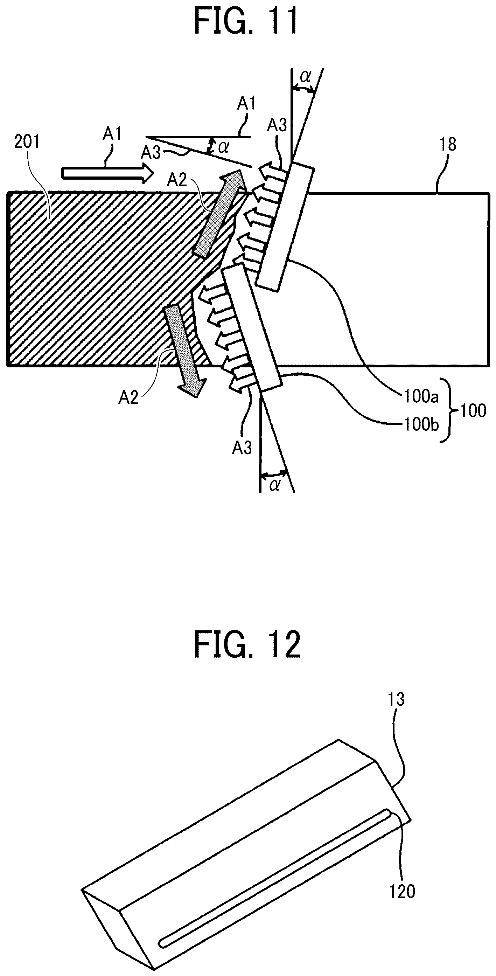

The poor-solvent application device is not particularly limited, as long as it has a slit nozzle and applies the solvent without contacting the substrate, and can be appropriately selected depending on the purpose. The slit nozzle refers to a nozzle having a slit-shaped discharge port, capable of spraying a liquid from the slit in a relatively uniform film-like form. An example thereof is illustrated in FIG. 12, in which a poor-solvent application device 13 includes a slit nozzle 120. The poor-solvent application device 13 may include a single slit nozzle or a plurality of slit nozzles.

The poor-solvent application device is preferably a device that drops only liquid droplets by water pressure or by gravity without using air, from the viewpoint of preventing application misalignment caused by the influence of airflow.

FIG. 5 is a perspective explanatory view of an apparatus for producing a perovskite solar cell according to one embodiment of the present invention, and depicts the application and removal of the poor solvent by the poor solvent application device and the poor-solvent removal device.

The precursor ink is applied by the perovskite precursor application device 11, and excess solvent is removed by the drying device to form a precursor ink film 19. A poor solvent 17 is then applied from above onto the precursor ink film 19 by the poor-solvent application device 13. The precursor ink film 19 to which the poor solvent 17 has been applied is transported to the poor-solvent removal device 15 by moving the substrate 18, where the poor solvent 17 is removed.

By keeping the substrate in a horizontal state, the poor solvent is retained on the substrate and prevented from falling off the substrate before it reaches the poor-solvent removal device. Further, since the poor-solvent application time is determined by the positions of the poor-solvent application device and the poor-solvent removal device and the transport speed of the substrate, the poor-solvent application time can be controlled by controlling the transport speed.

The poor-solvent application device is effectively implemented in a configuration having a slit-nozzle shape. For example, the poor-solvent application device may employ a line-application method using a slit nozzle or the like, and by positioning the slit nozzle perpendicular to the transport direction of the substrate, uniform application across the surface can be achieved as the substrate is transported.

The poor-solvent application device is effectively implemented in a configuration having a slit-nozzle shape. By positioning the slit nozzle perpendicular to the transport direction of the substrate, uniform application across the surface can be achieved as the substrate is transported.

### <Transport device>

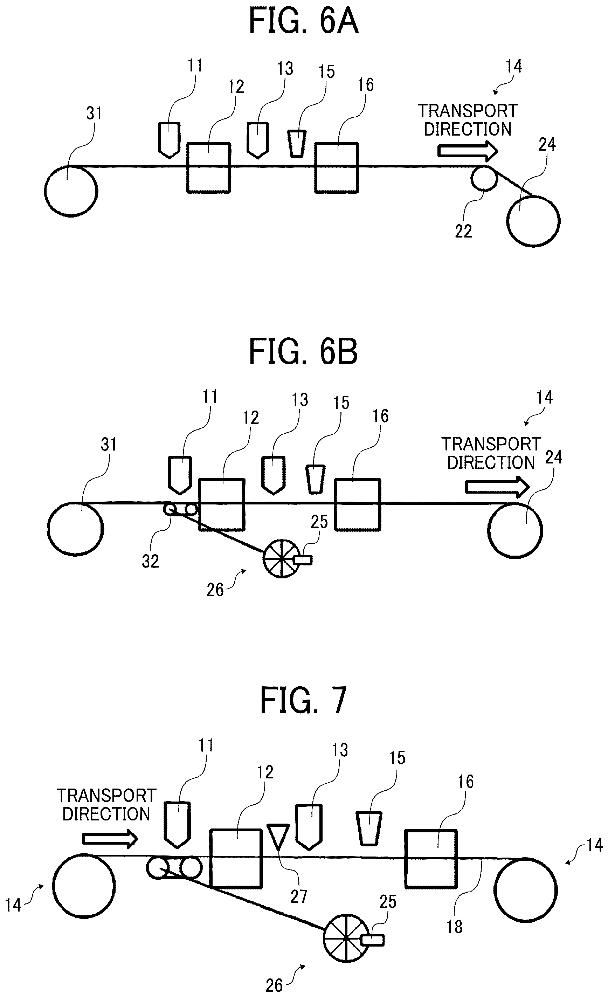

The transport device 14 continuously transports the substrate horizontally at least during a period from when the poor solvent is applied by the poor-solvent application device until when the poor solvent is removed by the poor-solvent removal device. The transport device 14 constitutes a roll-to-roll type transport device. The transport device 14 is described with reference to FIG. 6A and FIG. 6B.

FIG. 6A is a schematic view of a transport device in an apparatus for producing a perovskite solar cell according to one embodiment of the present invention, and FIG. 6B is a schematic view of another transport device in an apparatus for producing a perovskite solar cell according to one embodiment of the present invention.

As presented in FIG. 6A, the transport device 14 includes the unwinding roller 31, the winding roller 24, and a grip roller 22. The unwinding roller 31 rotates in accordance with driving of a motor to feed out the substrate before formation of the perovskite precursor film. The winding roller 24 rotates in accordance with driving of a motor to wind up the substrate after formation of the perovskite precursor film. The grip roller 22 is a roller that grips the substrate on an upstream side of the winding operation, is in contact with the substrate, and restrains the substrate at a contact surface by a means such as suction air. Further, the grip roller 22 is a roller capable of controlling the speed of the substrate by being controlled by a drive motor.

Further, as presented in FIG. 6B, the transport device 14 may include a nip belt 32 instead of the grip roller 22 in the transport device illustrated in FIG. 6A. The nip belt 32 includes a belt portion that is in contact with the substrate and grips the substrate via the contact portion. The gripping mechanism of the substrate is configured to restrain the substrate and the belt using a means such as suction air.

The transport device includes a wheel encoder 25 for detecting the transport speed.

The transport speed of the transport device is controlled by controlling a motor based on a target value and a detected speed value obtained by sampling detection pulses from the wheel encoder.

In the poor-solvent application step of the present specification, it is effective to control the applied amount of the poor solvent to a minimum necessary level in order to prevent scattering of the poor solvent into the air. A configuration example for optimizing the applied amount of the poor solvent is illustrated in FIG. 7.

The transport device 14 may include, on a substrate transport path, a substrate transport amount detection device 26 or a precursor ink film detection device 27. The substrate transport amount detection device 26 may be a detection device employing the wheel encoder 25 installed on a rotation shaft of the nip belt 32. When the nip belt 32 contacts the substrate and rotates together, the substrate transport amount detection device detects the transport amount of the substrate based on the amount of rotation of the wheel encoder 25. Based on the detected result, the amount of movement from the perovskite precursor application device to the poor-solvent application device is determined, and a discharge timing of the poor-solvent application device is controlled.

Further, it is preferable that discharge of the poor solvent is stopped after the substrate has been transported by an amount corresponding to a pattern of the perovskite precursor application, so that the poor solvent is applied only onto the perovskite precursor film. In the precursor ink film detection device, a detection mark is provided in advance on the substrate, or the start of printing of the perovskite precursor film is detected, thereby serving as a trigger for starting application of the poor solvent.

### <Poor-solvent removal device>

The poor-solvent removal device is a device for removing the poor solvent from the perovskite precursor film to which the poor solvent has been applied. The degree of removal is not particularly limited, as long as at least a part of the poor solvent in the perovskite precursor film is removed.

The poor-solvent removal device is not particularly limited and can be appropriately selected according to the purpose. Examples of the poor-solvent removal device that can be effectively used include, but are not limited to, a non-contact, line-shaped air knife.

The poor-solvent removal device can employ a method of moving the poor solvent by applying an external force, and for example, a poor-solvent removal device that blows air or the like from a slit-shaped gap, such as an air knife, can be used.

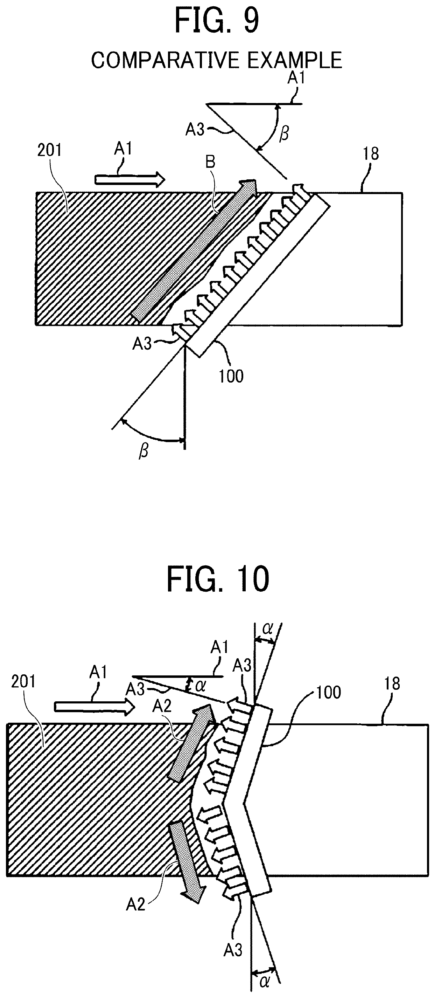

In FIG. 5, the poor-solvent application device is arranged parallel to a width direction of the substrate. However, as illustrated in FIG. 9, it may be arranged so as to have an inclination angle with respect to the width direction of the substrate. In this case, it is preferable that the inclination angles of the poor-solvent application device and the removal device are matched (i.e., arranged parallel to each other), since this makes it possible to keep the poor-solvent application time constant in the width direction.

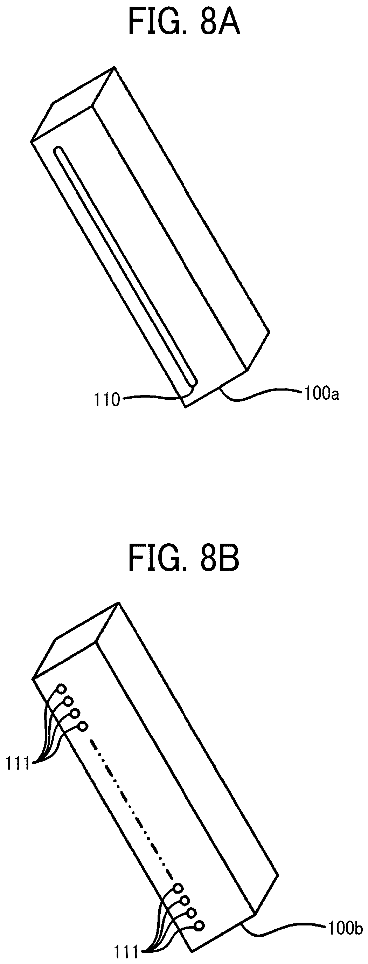

FIGs. 8A and 8B are explanatory views of air discharge ports of members constituting air knives 100a and 100b, respectively. Each of FIGs. 8A and 8B is the same as an air knife 100 illustrated in FIG. 9, described below. As illustrated in FIG. 8A, the air discharge port can be a slit-shaped air discharge port 110 extending in the width direction of the air knife. Alternatively, as illustrated in FIG. 8B, the air discharge ports can be a plurality of opening-shaped air discharge ports 111 arranged in the width direction of the air knife.

In a general poor-solvent removal device, the air knife 100 is arranged so as to be inclined (for example, at an angle β) with respect to the width direction of the substrate, as illustrated in FIG. 9. As indicated by arrow B, the poor solvent to be removed moves in the width direction of the substrate 18. A hatched region 201 represents a region in which a liquid film composed of the poor solvent is formed.

In the example illustrated in FIG. 9, the air knife 100 discharges air in a vertical direction from a side surface provided with the air discharge ports. Both the angle of the side surface with respect to the width direction of the substrate 18 and the angle of an air discharge direction A3 with respect to a transport direction A1 of the substrate (i.e., a relative movement direction of the object to which air is blown and the air knife) are equal to β. In the present specification, the inclination angle of the side surface of the air knife provided with the air discharge ports with respect to a direction perpendicular to the substrate width direction on the substrate surface (i.e., the substrate transport direction A1) is referred to as an "angle of the air knife".

In order to secure a time during which the poor solvent moves by a distance corresponding to the width of the substrate, the angle of the air knife is increased. However, this causes variation in the time required for the poor solvent to be removed in the width direction of the substrate.

Accordingly, in the present embodiment, as illustrated in FIG. 10, the air knife 100 in which the air discharge direction is changed at the center of the width of the substrate is used, thereby limiting the distance over which the poor solvent to be removed moves, as indicated by an arrow A2, to approximately half of the width of the substrate 18. The air knife 100 illustrated in FIG. 10 is formed as a single member, and is characterized in that the position of the slit of the discharge port is inclined from the front to back.

Specifically, the slit is inclined such that air is blown, from the center of the liquid film in the width direction towards both ends, in a direction inclined with respect to the transport direction A1. The air discharge direction is indicated by an arrow A3 in the drawing. In the illustrated example, the air knife 100 discharges air in a vertical direction from a side surface provided with the air discharge ports. The angle of the air knife and the angle of the air discharge direction A3 with respect to the transport direction A1 are both equal to α.

As a result, the angle of the air knife can be kept small, such as α (<β). Accordingly, variation in the time required for removal of the poor solvent in the width direction of the substrate can be reduced, thereby improving uniformity of the perovskite film.

Further, as illustrated in FIG. 11, similarly, by arranging a pair of short air knife members 100a, 100b side by side, it is possible to reduce the distance over which the poor solvent to be removed moves, minimize variation in the time required for removal of the poor solvent in the width direction of the substrate, and improve uniformity of the perovskite film.

The embodiments described above are merely illustrative, and the present invention exhibits specific effects in each of the following aspects.

In the description of the following aspects, reference numerals following the names of constituent elements indicate examples of the corresponding members, and embodiments of the present invention is not limited to these examples of the members.

### (Aspect 1)

A poor-solvent removal device 15 for removing a poor solvent adhered to the surface of a substrate 18 by blowing air from an air knife 100, in which the air is blown, from a center of a liquid film in a width direction perpendicular to a relative movement direction of the substrate 18 and the air knife 100 toward both ends, in a direction inclined with respect to the relative movement direction.

In the present specification, the "center" of the liquid film in the width direction perpendicular to the relative movement direction of the air knife refers to a region within a central one-third of a total width of the liquid film in the width direction perpendicular to the relative movement direction of the air knife, obtained by dividing the total width into three equal parts.

According to this configuration, by pushing the poor solvent liquid from the center of the liquid film towards both ends, variation in a liquid contact time in the width direction of the object can be reduced.

### (Aspect 2)

The poor-solvent removal device 15 according to Aspect 1, in which the center is a region within a central one-seventh of the total width of the poor solvent in the width direction, obtained by dividing the total width into seven equal parts.

According to this configuration, variation in the liquid contact time in the width direction of the object can be sufficiently reduced.

### (Aspect 3)

The poor-solvent removal device 15 according to Aspect 1 or 2, in which the air knife 100 includes a slit-shaped air discharge port extending in the width direction or a plurality of opening-shaped air discharge ports arranged in the width direction, the extending direction or arranging direction of the air discharge ports being inclined with respect to the width direction such that the both ends are located downstream of the center in the relative movement direction.

According to this configuration, variation in the liquid contact time in the width direction of the object can be reduced by the shape of the air knife provided with the air discharge ports.

### (Aspect 4)

The poor-solvent removal device 15 according to Aspect 1 or 2, in which the air knife 100 includes a pair of air knife 100 members, each provided with a slit-shaped air discharge port extending in the width direction or a plurality of opening-shaped air discharge ports arranged in the width direction, and each covering a widthwise half of the total width of the poor solvent from the center toward the respective ends. The pair of air knife 100 members are arranged such that central-side end portions overlap each other in the relative movement direction, and the extending direction or arranging direction is inclined with respect to the width direction such that edge-side end portions are located downstream of the central-side end portions in the relative movement direction.

According to this configuration, downsizing of the air knife can be achieved.

### (Aspect 5)

The poor-solvent removal device 15 according to any one of Aspects 1 to 4, in which the substrate 18 is a continuous sheet-shaped object supplied from a roll-shaped supply unit.

According to this configuration, productivity of the liquid film removal device can be increased as compared with a configuration using a cut-sheet-shaped object.

### (Aspect 6)

The poor-solvent removal device 15 according to Aspect 5 further including a backup device that backs up the continuous sheet-shaped substrate 18 at a position where the air from the air knife 100 is applied. According to this configuration, removal of the liquid film can be stabilized.

### (Aspect 7)

A perovskite film forming apparatus for forming a perovskite film on a substrate, including:
a perovskite precursor application device 11 that applies a perovskite precursor solution onto the substrate;
a poor-solvent application device 13 that applies a precipitation liquid for precipitating perovskite crystals on the substrate after application of the precursor solution; and
a poor-solvent removal device 15 that removes the poor solvent on the substrate after application of the precipitation liquid, in which the poor-solvent removal device 15 is the poor-solvent removal device 15 according to any one of Aspects 1 to 6. The precipitation liquid is preferably a poor solvent for perovskite.

According to this configuration, a uniform perovskite film can be formed.

### (Aspect 8)

A liquid film removal method for removing a poor solvent adhered to a surface of a substrate 18 by blowing air from an air knife 100, in which the air is blown so as to push a poor solvent liquid from the center toward both ends in a width direction perpendicular to a relative movement direction of the substrate 18 and the air knife 100.

According to this method, variation in a liquid contact time in the width direction of the object can be reduced.

### (Aspect 9)

A perovskite film forming method for forming a perovskite film on a substrate, including:
a precursor solution application step of applying a perovskite precursor solution onto the substrate;
a precipitation liquid application step of applying, onto the substrate to which the precursor solution has been applied, a precipitation liquid for precipitating perovskite crystals on the substrate; and
a liquid film removal step of removing a poor solvent on the substrate after application of the precipitation liquid in the precipitation liquid application step, in which, in the liquid film removal step, the liquid film removal method according to Aspect 8 is used.

According to this method, a uniform perovskite film can be formed.

### (Aspect 10)

A method for producing a perovskite solar cell including a perovskite film forming step, in which, in the perovskite film forming step, the perovskite film forming method according to Aspect 9 is used.

According to this method, a solar cell including a uniform perovskite layer and exhibiting favorable performance can be provided.

### (Aspect 11)

A perovskite solar cell produced by the method for producing a perovskite solar cell according to Aspect 10.

According to this configuration, a perovskite solar cell including a uniform perovskite layer and exhibiting favorable performance as a solar cell can be obtained.

### <Baking device>

The baking device is a device for baking a perovskite precursor film from which the poor solvent has been removed.

The baking device is not particularly limited as long as it is capable of baking the perovskite precursor film, and can be appropriately selected according to the purpose. For example, the perovskite precursor film can be heated to a temperature at which the perovskite precursor film is baked by a heating device. Examples of the heating device include, but are not limited to, a hot-air heater and an infrared heater.

The embodiments of the present invention have been described above in detail. The above-described embodiments are merely specific examples for carrying out the present invention. The contents of the embodiments do not limit the technical scope of the present invention, and many design modifications, including changes, additions, and deletions of constituent elements, can be made without departing from the spirit of the invention as defined in the claims. New embodiments resulting from such design modifications possess synergistic effects of the embodiments and modifications that are combined. In the above-described embodiments, matters for which such design modifications are possible are emphasized using expressions such as "in the present embodiment" or "according to the present embodiment". However, design modifications are also permitted for matters not accompanied by such expressions. Any combination of the above-described constituent elements is effective as an aspect of the present invention.

### [Examples]

Hereinafter, embodiments of the present invention are described in more detail with reference to examples. However, embodiments of the present invention are not limited to the following examples.

### (Example 1)

### <Preparation of electron transport layer ink>

A tin oxide colloidal solution (S-8 manufactured by Taki Chemical Co., Ltd.) was diluted with an equal amount of ultrapure water. As a surfactant, Triton X (manufactured by Sigma-Aldrich) was added in an amount of 0.1 wt%.

### <Preparation of perovskite precursor ink>

In a nitrogen-atmosphere glove box, cesium iodide and formamidinium iodide as compounds containing one or more types of monovalent cations; lead iodide and lead bromide as compounds containing one or more types of divalent metal cations; and methylammonium bromide and methylammonium chloride as compounds containing one or more types of halide anions were weighed in amounts of 1.3 g, 16.0 g, 48.38 g, 0.75 g, 0.21 g, and 1.01 g, respectively. Thereafter, under an atmosphere at 20°C, dimethyl sulfoxide and N,N-dimethylacrylamide were added in amounts of 16.7 g and 80.7 g, respectively. The mixture was then stirred to prepare a clear perovskite precursor liquid composition.

### <Preparation of hole transport layer ink>

After weighing 3 g of poly[bis(4-phenyl)(2,4,6-trimethylphenyl)amine] (PTAA, manufactured by Sigma-Aldrich), the PTAA was dissolved in 100 g of ortho-dichlorobenzene.

### <Production of photoelectric conversion element>

A photoelectric conversion element was produced using the apparatus illustrated in FIG. 2. A substrate was set in a belt-type transport device, and layers including the electron transport layer were sequentially formed one by one. As necessary, laser processing was performed to form a pattern.

A 300 mm square ITO substrate of 10 Ω/sq was subjected to UV/O₃ cleaning. An electron transport layer ink was applied onto the substrate using an electron transport layer application device (die coater), and the solvent of the electron transport layer ink was dried by a drying device at 170 °C for 30 seconds. The film thickness of the obtained electron transport layer was 45 nm. Thereafter, for multi-cell formation, the ITO was cut using a laser processing machine.

Next, a precursor ink was applied onto the substrate using a perovskite precursor application device (die coater), and the solvent of the precursor ink was dried by a drying device. Thereafter, a poor solvent (chlorobenzene) was applied onto the precursor ink film using a poor-solvent application device (slit-nozzle type). Excess solvent was then removed using a poor-solvent removal device as illustrated in FIG. 9, followed by final crystallization at 170 °C for 30 seconds by a baking device. The film thickness of the obtained perovskite layer was 450 nm. Note that the configurations illustrated in FIG. 5 were used for the poor-solvent application device and the poor-solvent removal device.

Subsequently, a hole transport layer ink was applied using a hole transport layer application device (die coater), and the solvent of the hole transport layer ink was dried at 170 °C for 30 seconds by a drying device. The film thickness of the obtained hole transport layer was 60 nm. Thereafter, ITO was exposed at interconnection portions between cells using a laser processing machine.

Next, a 100 nm gold film was formed in a vacuum using a deposition mask by a vacuum deposition device.

Finally, a sealing film and a UV cut film were laminated using a thermocompression laminator. Through the above steps, a photoelectric conversion element module was obtained.

### <Evaluation of photoelectric conversion characteristics>

The obtained photoelectric conversion element module was evaluated for photoelectric conversion characteristics (initial characteristics) while being irradiated with light from a solar simulator (AM 1.5, 100 mW/cm²). The evaluation was performed using a DC voltage-current devicer (B2910BL manufactured by Keysight Technologies) controlled by Solar Cell I-V Measurement Software manufactured by Systemhouse Sunrise Corp. Note that the photoelectric conversion module is configured with 15 cells connected in series, and solar cell evaluation can be performed for each individual cell. The results are presented in Table 1.

### <Example 2>

A series of evaluations was carried out in the same manner as in Example 1, except that the application method used in the application devices (the electron transport layer application device, the perovskite precursor application device, and the hole transport layer application device) in Example 1 was changed from a die coater method to an inkjet method. The results are presented in Table 1.

### <Example 3>

A series of evaluations was carried out in the same manner as in Example 2, except that the substrate used in Example 2 was changed to a 300-mm-wide ITO film roll, and a photoelectric conversion element was produced using the apparatus illustrated in FIG. 3 with a roll-to-roll method (with the substrate being transported horizontally). Note that the photoelectric conversion element module was obtained by cutting the film roll, which was partitioned in units of a 300-mm width, into pieces having the same 300-mm square size as in Example 2. The results are presented in Table 1.

### <Example 4>

A series of evaluations was carried out in the same manner as in Example 1, except that the removal member used in Example 1 was changed from the member illustrated in FIG. 9 to the member illustrated in FIG. 10. The results are presented in Table 1.

### <Comparative example 1>

A series of evaluations was carried out in the same manner as in Example 1, except that the poor-solvent application device in Example 1 was changed to a spray-type device. Note that the spray nozzles were arranged in a total of five nozzles evenly distributed across a width of 300 mm, and a gap between the substrate and the nozzle surface was set to 10 cm. The results are presented in Table 1.

**Table 1**

| | Cell No./Conversion efficiency (%) | | | | | | | | | | | | | | | Standard deviation σ | Average values |
|---|---|---|---|---|---|---|---|---|---|---|---|---|---|---|---|---|---|
| | 1 | 2 | 3 | 4 | 5 | 6 | 7 | 8 | 9 | 10 | 11 | 12 | 13 | 14 | 15 | | |
| Example 1 | 12.3 | 13.7 | 14.3 | 14.5 | 14.8 | 14.7 | 14.5 | 14.8 | 14.6 | 14.8 | 14.7 | 14.5 | 14.6 | 13.5 | 12.2 | 0.84 | 14.17 |
| Example 2 | 15.1 | 15.2 | 15 | 15.1 | 15.2 | 15.2 | 15.3 | 15.4 | 15.4 | 15.4 | 15.3 | 15.2 | 15.2 | 15.1 | 15.2 | 0.12 | 15.22 |
| Example 3 | 15.2 | 15.3 | 15.2 | 15.2 | 15.2 | 15.3 | 15.4 | 15.3 | 15.3 | 15.2 | 15.2 | 15.2 | 15.3 | 15.3 | 15.2 | 0.06 | 15.25 |
| Example 4 | 15.2 | 15.2 | 15.1 | 15.1 | 15.1 | 15.1 | 15.2 | 15.3 | 14.9 | 15.2 | 15.2 | 15.2 | 15.1 | 15.1 | 15.0 | 0.09 | 15.14 |
| Comparative example 1 | 10.2 | 13.2 | 10.3 | 11.2 | 13.6 | 11.5 | 11.2 | 13.2 | 10.7 | 10.9 | 13.5 | 10.7 | 10.8 | 13.3 | 10.8 | 1.24 | 11.67 |

Further, it can be found that, by applying each layer of the photoelectric conversion element using an inkjet method (Example 2), the standard deviation is smaller and variation between cells is reduced as compared with the case where the layers are applied using a die coater (Example 1). In addition, by adopting a roll-to-roll method (with the substrate being transported horizontally) (Example 3), this effect becomes even more pronounced.

Further, by changing the removal device to the member illustrated in FIG. 10, variation in the time from application to removal of the poor solvent is reduced, and therefore both the average value and the standard deviation are improved as compared with Example 1 (Example 4).

Aspects of the present invention include, for example, the following.

### <Aspect 1>

An apparatus for producing a perovskite solar cell, that includes:
a perovskite precursor application device that applies a perovskite precursor ink onto a substrate to form a perovskite precursor film;
a drying device that dries the perovskite precursor film;
a poor-solvent application device that applies a poor solvent from a slit nozzle to the dried perovskite precursor film in a direction perpendicular to the substrate without contacting the perovskite precursor film;
a transport device that horizontally transports the substrate to which the poor solvent has been applied;
a removal device that removes the poor solvent from the perovskite precursor film that has been horizontally transported; and
a baking device that bakes the perovskite precursor film from which the poor solvent has been removed.

### <Aspect 2>

The apparatus for producing a perovskite solar cell according to <Aspect 1>, in which the perovskite precursor application device is an inkjet nozzle.

### <Aspect 3>

The apparatus for producing a perovskite solar cell according to <Aspect 1> or <Aspect 2>, in which the transport device employs a roll-to-roll method.

### <Aspect 4>

The apparatus for producing a perovskite solar cell according to <Aspect 3>, in which the poor-solvent application device applies the poor solvent in a width direction of the substrate by the roll-to-roll method.

### <Aspect 5>

The apparatus for producing a perovskite solar cell according to <Aspect 1> to <Aspect 4>, in which the removal device is an air knife that blows air, from a center of a liquid film in the width direction of the substrate toward both ends of the liquid film, in a direction inclined with respect to a relative movement direction.

### <Aspect 6>

The apparatus for producing a perovskite solar cell according to <Aspect 5>, in which the center is within a central one-seventh of a total width of the liquid film in the width direction, obtained by dividing the total width into seven equal parts.

### <Aspect 7>

The apparatus for producing a perovskite solar cell according to <Aspect 5>, in which the air knife includes a slit-shaped air discharge port extending in the width direction or a plurality of opening-shaped air discharge ports arranged in the width direction, the extending direction or the arranging direction being inclined with respect to the width direction such that the both ends are located downstream of the center in the relative movement direction.

### <Aspect 8>

A method for producing a perovskite solar cell, including:
applying a perovskite precursor ink onto a substrate to form a perovskite precursor film;
drying the perovskite precursor film;
applying a poor solvent from a slit nozzle to the dried perovskite precursor film in a direction perpendicular to the substrate without contacting the substrate;
horizontally transporting the substrate to which the poor solvent has been applied;
removing the poor solvent from the perovskite precursor film to which the poor solvent has been applied; and
baking the perovskite precursor film from which the poor solvent has been removed.

### <Aspect 9>

The method for producing a perovskite solar cell according to <Aspect 8>, in which the substrate is transported horizontally in the transport step.

### <Aspect 10>

The method for producing a perovskite solar cell according to <Aspect 8> or <Aspect 9>, further including:
applying a first carrier transport layer precursor ink onto the substrate to form a first carrier transport layer; and
applying a second carrier transport layer precursor ink onto the substrate to form a second carrier transport layer.

Any one of the above-described operations may be performed in various other ways, for example, in an order different from the one described above.

## Claims

1. An apparatus (10) for producing a perovskite solar cell, the apparatus comprising:
a perovskite precursor application device (11) configured to apply a perovskite precursor ink onto a substrate (18) to form a perovskite precursor film (19);
a drying device (12) configured to dry the perovskite precursor film (19);
a poor-solvent application device (13) configured to apply a poor solvent (17) from a slit nozzle (120) to the perovskite precursor film (19) that has been dried in a direction perpendicular to the substrate (18) without contacting the perovskite precursor film (19);
a transport device (14) configured to horizontally transport the substrate (18) to which the poor solvent (17) has been applied;
a removal device (15) configured to remove the poor solvent (17) from the perovskite precursor film (19) that has been horizontally transported; and
a baking device (16) configured to bake the perovskite precursor film (19) from which the poor solvent (17) has been removed.

2. The apparatus (10) according to claim 1, wherein the perovskite precursor application device (11) is an inkjet nozzle.

3. The apparatus (10) according to claim 1 or 2, wherein the transport device (14) employs a roll-to-roll method.

4. The apparatus (10) according to claim 3, wherein the poor-solvent application device (13) applies the poor solvent (17) in a width direction of the substrate (18) by the roll-to-roll method.

5. The apparatus (10) according to any one of claims 1 to 4, wherein the removal device (15) is an air knife (100) that blows air, from a center of a liquid film (201) in a width direction of the substrate (18) toward both ends of the liquid film, in a direction (A3) inclined with respect to a relative movement direction (A1).

6. The apparatus (10) according to claim 5, wherein the center is within a central one-seventh of a total width of the liquid film (201) in the width direction, obtained by dividing the total width into seven equal parts.

7. The apparatus (10) according to claim 5, wherein the air knife (100) includes a slit-shaped air discharge port (110) extending in the width direction or a plurality of opening-shaped air discharge ports (111) arranged in the width direction, the extending direction or the arranging direction being inclined with respect to the width direction such that the both ends are located downstream of the center in the relative movement direction (A1).

8. A method for producing a perovskite solar cell, the method comprising:
applying a perovskite precursor ink onto a substrate (18) to form a perovskite precursor film (19);
drying the perovskite precursor film (19);
applying a poor solvent (17) from a slit nozzle (120) to the perovskite precursor film (19) that has been dried in a direction perpendicular to the substrate (18) without contacting the substrate (18);
horizontally transporting the substrate (18) to which the poor solvent (17) has been applied;
removing the poor solvent (17) from the perovskite precursor film (19) to which the poor solvent (17) has been applied; and
baking the perovskite precursor film (19) from which the poor solvent (17) has been removed.

9. The method according to claim 8, further comprising:
applying a first carrier transport layer precursor ink onto the substrate (18) to form a first carrier transport layer; and
applying a second carrier transport layer precursor ink onto the substrate (18) to form a second carrier transport layer.
